# FASCICULE DE BREVET EUROPEEN

(11) **EP 2 954 339 B1**
(45) Date de publication et mention de la délivrance du brevet: **10.05.2017**
(21) Numéro de dépôt: 14702850.0
(22) Date de dépôt: 05.02.2014
(51) Int. Cl.: G01R 15/18, G01R 19/25, H02H 3/04, G01R 31/327

(54) **DISPOSITIF DE TRAITEMENT DE SIGNAL DANS UNE INSTALLATION ELECTRIQUE**
VORRICHTUNG ZUR SIGNALVERARBEITUNG IN EINER ELEKTRISCHEN ANLAGE
DEVICE FOR SIGNAL PROCESSING IN AN ELECTRICAL INSTALLATION

(30) Priorité: 06.02.2013 FR 1351003
(43) Date de publication de la demande: 16.12.2015
(73) Titulaire: General Electric Technology GmbH, 5400 Baden (CH)
(72) Inventeur: RAYON, Jean-Luc, 69250 Montanay (FR); GRANELLI, Guillaume, 38530 Chapareillan (FR); MIRONNEAU, Jean-François, 69003 Lyon (FR)
(74) Mandataire: Brevalex
(86) Numéro de dépôt international: PCT/EP2014/052233
(87) Numéro de publication internationale: WO 2014/122168

(56) Documents cités:
- US-A- 4 484 136
- US-A1- 2005 243 484
- US-A1- 2010 085 671
- CHATREFOU D ET AL: "Interoperability Between Non Conventional Instrument Transformers (NCIT) and Intelligent Electronic Devices (IDE)", PES TD 2005/2006 MAY 21-24, 2006, PISCATAWAY, NJ, USA,IEEE, PISCATAWAY, NJ, USA, 21 mai 2006 (2006-05-21), pages 1274-1279, XP031331232, ISBN: 978-0-7803-9194-9

## Description

### DOMAINE TECHNIQUE

La présente invention concerne de manière générale l'électronique de puissance et la mesure et le traitement de paramètres électriques dans une installation électrique.

### ÉTAT DE LA TECHNIQUE ANTÉRIEURE

US 2005/243484 A1 (3 novembre 2005) décrit un dispositif de traitement des signal comportant des premiers moyens d'entrée destinés à être connectés via un capteur de mesure à un signal de haute tension d'une installation électrique et des moyens de traitement destinés à analyser le signal mesuré par ledit capteur.

Une installation électrique, comme par exemple un alternateur ou une sous-station électrique, est un élément du réseau électrique servant à la production, à la transmission ou à la distribution d'électricité. Par exemple, les sous-stations électriques se trouvent aux extrémités des lignes de transmission ou de distribution d'électricité, c'est-à-dire en bout du réseau électrique.

Une sous-station électrique comporte plusieurs étages de convertisseurs électroniques qui permettent de réduire une forte tension provenant des câbles haute tension, en une tension standardisée afin de la fournir aux consommateurs.

L'entrée des étages de convertisseurs électroniques est appelée le bus primaire, qui est lui-même connecté aux lignes hautes tension qui rentrent dans l'installation électrique tandis que la sortie des étages est appelée le bus secondaire, qui est connecté aux lignes de tension secondaires qui sortent de la sous-station.

La connaissance de la valeur du signal électrique de haute tension est nécessaire afin d'estimer la qualité du redressement effectué ainsi que pour mettre en oeuvre des techniques de modulation pour la commande du découpage.

Dans ce but, des capteurs de courant spécifiques sont intégrés dans les sous-stations électriques, sur le bus primaire, ou les bus secondaires.

Afin de fournir des mesures précises et fiables du courant, on utilise traditionnellement des capteurs de type flux zéro, appelés également capteurs conventionnels, c'est-à-dire avec noyau magnétique.

Les capteurs flux zéro utilisent le principe de l'effet Hall pour mesurer une tension proportionnelle à l'intensité du courant grâce à des tores secondaires de mesure, isolés du bus primaire dans lequel circule le courant. Une électronique de contre-réaction permet d'annuler le flux magnétique continu et donc d'éviter la saturation des noyaux magnétiques.

De tels capteurs sont capables de mesurer des formes d'onde de courants, alternatifs et complexes tout en assurant une isolation galvanique. Par ailleurs, ils présentent l'avantage d'avoir une large bande passante, du DC jusqu'à quelques dizaines de kHz.

En courant continu, la mesure du courant par des capteurs de type «flux zéro » est cependant limitée pour des tensions de l'ordre de 500 kV, car au-delà, l'isolation entre le tore primaire et le secondaire est prohibitive en terme de coût, de poids et d'encombrement et des effets magnétiques non maîtrisés peuvent rendre le capteur instable thermiquement et potentiellement dangereux. En effet, l'isolation entre le tore primaire et le secondaire, utilise des liquides ou des gaz sous pression.

De nouvelles technologies de capteurs, ou transformateurs de mesure, destinées à dépasser le seuil des 500 kV sont apparues. Ces derniers ne comportent pas de noyaux magnétiques et sont communément nommés capteurs non conventionnels ou NCIT (pour Non Conventional Instruments Transformers).

Dans le cadre d'utilisation des capteurs NCIT, le signal de haute tension issu du bus primaire nécessite une chaîne de mesure réalisant un traitement particulier.

Ce traitement est effectué par un dispositif de traitement de signal raccordé au travers d'un réseau de communication basé sur Ethernet afin d'acheminer les valeurs aux relais de protection et d'autres équipements de l'installation électrique.

En termes de sécurité de fonctionnement, la validation du raccordement est impérative et la validation du cheminement des informations est primordiale.

Toutefois, un test point à point de câblage n'est pas possible puisque des éléments électroniques comme des interrupteurs peuvent se trouver dans l'architecture Ethernet.

Actuellement, pour vérifier l'intégrité du réseau, un opérateur modifie le fonctionnement du dispositif de traitement en le faisant passer en mode de test. Il le déconnecte du capteur NTIC mesurant le courant et/ou la tension et injecte à sa place un signal de référence avec lequel différents tests vont être effectués.

Lors de cette vérification, l'opérateur peut effectuer de mauvaises manipulations et par exemple déclencher par erreur la mise en action des relais de protection ou encore endommager le capteur, oublier de reconnecter certains sous-éléments entre eux ou encore se tromper à la reconnexion. Ces manipulations imposent de plus d'interrompre le fonctionnement de l'installation électrique pendant le temps que dure la vérification, ce qui est extrêmement couteux.

En outre, l'utilisation d'électronique à proximité de la zone haute tension HT est délicate.

L'objet de la présente invention est de remédier aux inconvénients précités en proposant un dispositif de traitement plus sécurisé et qui permet notamment d'éviter toute mauvaise manipulation.

### EXPOSÉ DE L'INVENTION

Cet objectif est atteint par un dispositif de traitement de signal comportant des premiers moyens d'entrée destinés à être connectés via un capteur de mesure à un signal de haute tension d'une installation électrique, et des moyens de traitement destinés à analyser le signal mesuré par ledit capteur, comportant :
- des moyens de basculement configurés pour faire basculer le fonctionnement du dispositif entre un mode test dans lequel le dispositif est déconnecté dudit signal de haute tension pour être connecté à un signal de test et un mode opératoire dans lequel le dispositif est déconnecté dudit signal de test pour être reconnecté audit signal de haute tension, et
- des seconds moyens d'entrée connectés auxdits moyens de traitement, lesdits moyens de traitement étant configurés pour actionner lesdits moyens de basculement de telle sorte que le dispositif fonctionne en mode test ou en mode opératoire selon que les seconds moyens d'entrée sont activés ou désactivés respectivement.

Ceci permet d'automatiser l'opération de test tout en maintenant fermée la chaîne complète de mesure, de sécuriser l'installation électrique et d'interdire toute fausse manipulation de la part d'un opérateur.

Selon un premier mode de réalisation, les seconds moyens d'entrée comportent un connecteur destiné à être raccordé à un générateur d'injection dudit signal de test. Le raccordement audit générateur d'injection active les seconds moyens d'entrée pour déclencher le basculement du dispositif en mode test, et la déconnexion dudit générateur d'injection désactive les seconds moyens d'entrée.

Avantageusement, le dispositif comporte une interface d'entrée de protection reliée audit connecteur.

Selon un deuxième mode de réalisation, le dispositif comporte une mémoire comprenant au moins un signal de test préenregistré, et l'activation des seconds moyens d'entrée déclenche le basculement du dispositif en mode test et le remplacement du signal haute tension par ledit signal de test préenregistré.

Avantageusement, lesdits moyens de basculement sont des moyens électroniques et/ou des moyens logiciels dont l'actionnement est commandé par les moyens de traitement.

Avantageusement, ledit signal de test est un signal à l'image dudit signal de haute tension.

Avantageusement, les premiers moyens d'entrée comportent un connecteur d'alimentation destiné à être connecté à une source d'alimentation et une pluralité de connecteurs de mesure destinés à être connectés à une pluralité de capteurs de mesure.

Avantageusement, le dispositif comporte en outre des moyens de conversion analogique/numérique pour convertir le signal haute tension mesuré par ledit capteur en un signal numérique, et des moyens de sortie pour délivrer une mesure numérique dudit signal.

L'invention vise également un système de mesure d'une grandeur physique d'un signal électrique de haute tension comportant un dispositif de traitement selon l'une quelconque des caractéristiques précédentes, et au moins un capteur non conventionnel NCIT connecté audit dispositif de traitement par une liaison optique.

L'invention vise aussi une installation électrique comportant le système de mesure selon les caractéristiques ci-dessus.

### BRÈVE DESCRIPTION DES DESSINS

D'autres caractéristiques et avantages de l'invention apparaîtront à la lecture du mode de réalisation préférentiel de l'invention fait à titre d'exemple non limitatif en référence aux figures jointes parmi lesquelles :
La Fig. 1 illustre de manière schématique une installation électrique comportant un système de mesure, selon l'invention ;
La Fig. 2 illustre de manière schématique le dispositif de traitement, selon l'invention ; et
La Fig. 3 illustre de manière schématique un système de mesure comportant plusieurs capteurs, selon l'invention.

### EXPOSÉ DÉTAILLÉ DE MODES DE RÉALISATION PARTICULIERS

L'idée à la base de l'invention est de faire passer le dispositif de traitement en mode test de façon automatique.

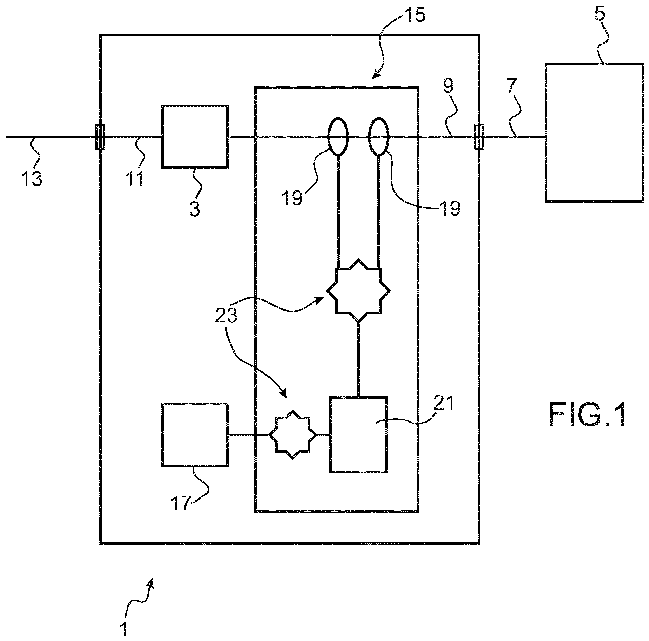

La Fig. 1 illustre de manière schématique une installation électrique comportant un système de mesure, selon l'invention.

L'installation électrique 1 (par exemple, un alternateur ou une sous-station) est un élément du réseau électrique qui se trouve aux extrémités des lignes de transmission d'électricité.

Une installation de type sous-station électrique comporte un ou plusieurs étages de convertisseurs électroniques 3 qui permettent de réduire une forte tension (de l'ordre de plusieurs dizaines de KV ou KA) provenant d'éléments générateurs 5 d'électricité via des câbles haute tension 7, en une tension standardisée (1/5A et 110/220V) afin de la fournir aux consommateurs, via des lignes de tension secondaires.

L'entrée des étages de convertisseurs électroniques 3 est appelée le bus primaire 9, qui est lui-même connecté aux lignes haute tension 7 qui rentrent dans l'installation électrique 1 tandis que la sortie des étages de convertisseurs 3 est appelée le bus secondaire 11, qui est connecté aux lignes de tension secondaires 13 qui sortent de l'installation électrique 1.

Dans les installations électriques modernes, comme les sous-stations AIS (Air Insulated Station) et GIS (Gas insulated Station), les étages de convertisseurs 3 sont commandés avec des fréquences de commutation importantes, une dynamique rapide et des tensions de l'ordre de 800 kV.

La connaissance de la valeur du signal du courant « complet ou composite » (c'est-à-dire du DC jusqu'à la plus haute fréquence AC) permet d'estimer la qualité du redressement effectué et de mettre en oeuvre des techniques de modulation pour la commande du découpage. Dans ce cas, la connaissance précise de la valeur du courant et/ou de la tension permet de régler les paramètres de modulation de manière optimale en vue de bloquer ou de mettre en saturation, au moment opportun, les commutateurs à semi-conducteur (type MOSFET, IGBT, thyristors) des convertisseurs.

De même, dans une installation électrique de type alternateur à vitesse variable (non représentée), ce dernier est généralement équipé d'onduleurs/redresseurs situés en amont du rotor de l'alternateur. Les onduleurs/redresseurs sont utilisés pour réguler la vitesse de rotation du rotor en lui envoyant un signal de courant à fréquence variable. On comprend alors que la mesure du signal de courant issu des onduleurs/redresseurs est importante pour la gestion de la puissance fournie par l'alternateur et pour la mise en oeuvre des systèmes de protection.

Dans ce but, un système de mesure 15 est intégré dans l'installation électrique 1 pour fournir des mesures précises et fiables d'une grandeur physique (courant ou tension) du signal électrique de haute tension du bus primaire. Ces mesures sont fournies à des équipements 17 de protection (relais et automates de contrôle) et de comptage (compteurs d'énergie et des qualimètres).

Ainsi, le système de mesure 15 comporte un ou plusieurs capteur(s) 19 monté(s) sur le bus primaire 9 de l'installation électrique 1 ainsi, qu'un dispositif de traitement 21 relié au(x) capteur(s) 19 par un ensemble de liaison 23.

Avantageusement, chaque capteur 19 est un capteur de type NCIT connecté au dispositif de traitement 21 par une liaison optique.

Le capteur NCIT ne comporte pas de noyau magnétique et son utilisation se justifie par une précision améliorée grâce à une absence de saturation magnétique, une sécurité intrinsèque, une compacité accrue, un autocontrôle permanent des capteurs, une absence de maintenance, une souplesse d'utilisation d'interface numérique, et une réduction globale des coûts.

Dans le domaine des NCIT plusieurs solutions technologiques de capteurs existent et le choix dépend de l'adéquation entre la facilité d'intégration, le coût propre des capteurs et leurs performances associées.

Ainsi, les capteurs NCIT peuvent être des capteurs Faraday ou des capteurs de Rogowski ou d'autres types de capteurs amagnétiques.

Par ailleurs, le système de mesure 15 est raccordé au travers des liaisons ou d'un réseau de communication 23 basé par exemple sur Ethernet 100MB utilisé également afin d'acheminer les valeurs aux équipements 17 de protection, de surveillance et de contrôle de l'installation électrique 1.

Dans le réseau de communication 23, les données sont de préférence transmises par fibre optique. Les fibres optiques sont en effet insensibles aux environnements hostiles et présentent une très faible conductivité thermique contribuant de ce fait à la précision des mesures et à la sécurité.

De plus, la liaison par fibre optique permet de placer le dispositif de traitement 21 à une certaine distance de sécurité vis-à-vis du bus primaire 9 de haute tension. On définit ainsi une zone haute tension HT proche du bus primaire 9 et une zone de basse tension BT proche du sol, là où sont situés le dispositif de traitement 21 et les équipements 17 de protection et de surveillance. Ainsi, seule la zone basse tension BT contient les éléments susceptibles d'être affectés par une défaillance.

L'isolement de la partie haute tension HT et la descente des fibres optiques sont réalisés par un isolateur composite de type résine-silicone contenant les fibres optiques utiles. Cette isolation est peu coûteuse et ininflammable.

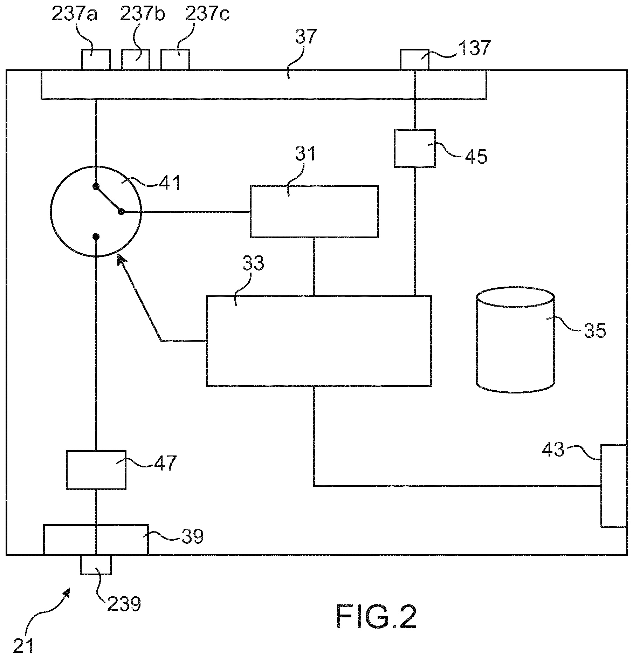

La Fig. 2 illustre de manière schématique le dispositif de traitement, selon l'invention.

Conformément à l'invention le dispositif de traitement 21 comporte des moyens de conversion analogique/numérique 31, des moyens de traitement 33, des moyens de mémoire 35 comprenant des paramètres de calibration, des premiers moyens d'entrée 37, des seconds moyens d'entrée 39, des moyens de basculement 41, et des moyens de sortie 43.

Les premiers moyens d'entrée 37 comportent un connecteur d'alimentation 137 destiné à être connecté à une source d'alimentation (non représentée) alternative ou continue issue de l'installation électrique. Le connecteur d'alimentation 137 alimente les moyens de traitement 33 via un convertisseur 45 de type AC/DC ou DC/DC.

En outre, les premiers moyens d'entrée 37 comportent un ou une pluralité de connecteur(s) de mesure 237a, 237b, 237c destiné(s) à être connecté(s) à un ou une pluralité de capteurs 19 de mesure monté(s) sur le bus primaire 9 de l'installation électrique 1 pour mesurer un signal de haute tension.

Les moyens de conversion analogique/numérique 31 sont destinés à convertir le signal haute tension mesuré par chaque capteur 19 en un signal numérique qui est ensuite analysé par les moyens de traitement 33. Ces derniers permettent de faire un traitement de grande précision de l'ordre de 32 bits, à une fréquence d'échantillonnage qui peut être de l'ordre de 20kHz.

Ensuite, les moyens de sortie 43 délivrent la mesure numérique traitée du signal au réseau de communication 23 qui l'achemine aux équipements 17 de protection, de surveillance et autres équipements de l'installation électrique 1.

Afin de vérifier l'intégrité de la chaîne de mesure et la validation du cheminement des informations, on utilise un signal de test à l'image du signal de haute tension qui peut être sinusoïdal. Le signal de test est un signal de faible niveau en termes d'amplitude de courant ou de tension mais de la même forme en termes de fréquence que le signal haute tension. L'opération de test permet de vérifier l'architecture du réseau de communication 23 et de tester toute la chaîne depuis les capteurs 19 jusqu'aux équipements 17 de protection et de surveillance qui peuvent être très éloignés des capteurs. Ainsi, cette opération de test permet à un opérateur de valider avant le démarrage de l'installation électrique 1, le fait que les mesures issues des capteurs 19 vont bien être reçues par les équipements 17 de protection et de surveillance.

Conformément à l'invention, l'opération de test est automatiquement réalisée par le dispositif de traitement 21.

En effet, les moyens de basculement 41 sont configurés pour faire basculer le fonctionnement du dispositif de traitement 21 entre un mode test (ou premier mode) et un mode opératoire (ou second mode) en fonction de l'activation ou la désactivation des seconds moyens d'entrée 39. Dans le premier mode, le dispositif de traitement 21 est déconnecté du signal de haute tension mesuré par chaque capteur 19 pour être connecté à un signal de test. Dans ce cas, le signal de test est converti en un signal numérique par les moyens de conversion analogique/numérique 31 avant d'être exploité par les moyens de traitement 33. En revanche, dans le second mode, le dispositif de traitement 21 est déconnecté du signal de test pour être reconnecté au signal de haute tension issu de chaque capteur 19.

Les seconds moyens d'entrée 39 sont bien entendus, connectés aux moyens de traitement 33 de sorte que ces derniers détectent l'activation ou la désactivation des moyens d'entrée 39.

Ainsi, les moyens de traitement 33 sont configurés pour actionner les moyens de basculement 41 de telle sorte que le dispositif de traitement 21 fonctionne en premier mode (mode de test) lorsque les seconds moyens d'entrée 39 sont activés ou en second mode (mode opératoire) lorsque les seconds moyens d'entrée 39 sont désactivés. Ceci permet de faire en sorte que le signal de test soit vu par les moyens de traitement 33 comme s'il était issu du bus primaire 9.

Les moyens de basculement 41 peuvent être des moyens électroniques, par exemple un commutateur dont l'actionnement est commandé par les moyens de traitement 33 dès que ces derniers détectent l'activation ou la désactivation des seconds moyens d'entrée.

En variante, les moyens de basculement 41 peuvent être des moyens logiciels mis en oeuvre par les moyens de traitement 33 en fonction de l'activation ou la désactivation des seconds moyens d'entrée 39.

Selon un premier mode de réalisation, l'activation des seconds moyens d'entrée 39 correspond à une injection d'un signal de test depuis l'extérieur du dispositif 21.

Plus particulièrement, les seconds moyens d'entrée 39 comportent un connecteur de test 239 destiné à être raccordé via un câble d'injection (non représenté), à un générateur d'injection du signal de test. Ainsi, le connecteur de test 239 permet d'injecter directement sur une entré bas niveau à l'aide d'un générateur du type Omicron 256 ou similaire un signal électrique qui peut être sinusoïdal et qui sera l'image du signal du bus primaire.

Le raccordement du générateur d'injection via le câble d'injection active les moyens d'entrée 39 et par conséquent déclenche le basculement du dispositif 21 en mode test.

Ainsi, le connecteur de test 39 en liaison avec les moyens de traitement 33 permet, quand est raccordé le câble d'injection, de le reconnaître et de faire passer grâce aux moyens de basculement 41, le dispositif de traitement 21 en mode test de façon automatique.

De même, le connecteur de test 239 en liaison avec les moyens de traitement 33 permet, quand le câble d'injection est déconnecté, de faire repasser grâce aux moyens de basculement 41, le dispositif de traitement 21 en mode opératoire de façon automatique.

Avantageusement, le dispositif comporte une interface d'entrée de protection 47 relié au connecteur de test 239. L'interface de protection 47 est une barrière de protection entre le générateur d'injection et les éléments du dispositif de traitement 21 permettant aux moyens de traitement 33 de directement exploiter le signal d'injection.

En effet, l'interface de protection 47 est un convertisseur/isolateur qui permet de protéger et d'isoler galvaniquement les éléments du dispositif de traitement 21 de son environnement. Autrement dit, c'est une barrière électronique qui empêche l'apparition des phénomènes transitoires dans les éléments du dispositif de traitement 21.

Selon un deuxième mode de réalisation, l'activation ou la désactivation des seconds moyens d'entrée est réalisée par un moyen de commande (par exemple, un connecteur clé) permettant l'utilisation d'un signal de test interne au dispositif de traitement 21.

Dans ce cas, le signal de test est un signal de test préenregistré dans les moyens de mémoire 35 de sorte que l'activation des seconds moyens d'entrée 39 par le connecteur clé déclenche le basculement du dispositif 21 en mode de test et le remplacement du signal de haute tension par le signal de test préenregistré.

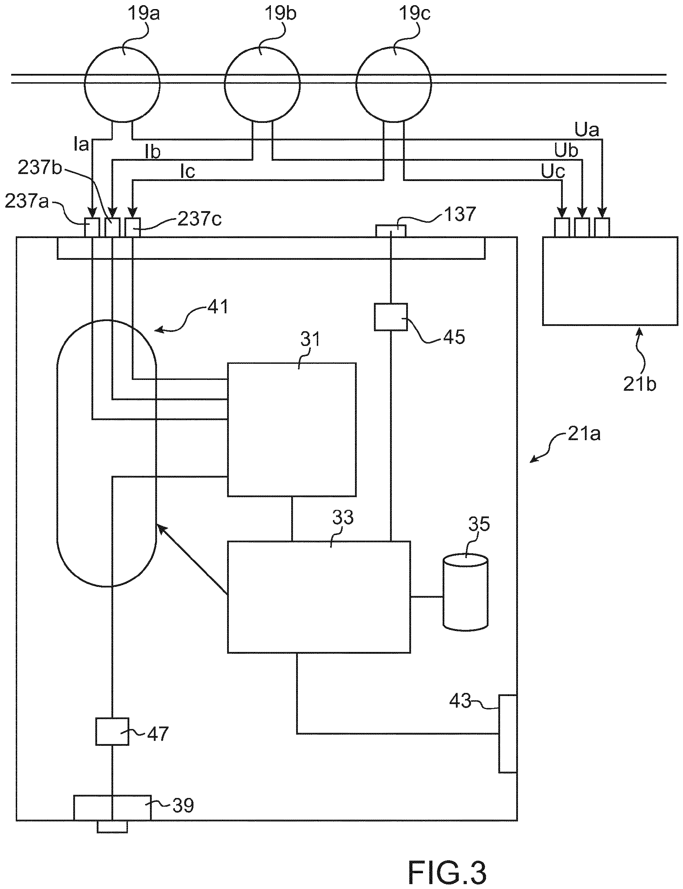

La Fig. 3 illustre de manière schématique un système de mesure comportant plusieurs capteurs, selon l'invention.

Les capteurs 19a, 19b, 19c sont montés sur un bus primaire 9 d'une installation électrique pour mesurer les différentes phases de courant Ia, Ib, Ic ou de tension Ua, Ub, Uc du signal de haute tension.

Selon cet exemple, les signaux de courant et de tension sont acheminés vers des premier et second dispositifs de traitement 21a, 21b respectivement.

Comme on peut le voir plus en détails sur le premier dispositif de traitement 21a, les trois signaux de courant Ia, Ib, Ic sont injectés dans trois connecteurs de mesure 237a, 237b, 237c respectivement des premiers moyens d'entrée 37.

Dans un mode opératoire les trois signaux de courant Ia, Ib, Ic sont convertis par les moyens de conversion analogique/numérique 31 en des signaux numériques qui sont ensuite analysés et multiplexés dans une trame de mesure par les moyens de traitement 33 avant d'être transmis par les moyens de sortie 43 aux équipements de protection et de surveillance via le réseau de communication.

On notera que dans le cas où les capteurs sont de type Rogowski, les signaux numériques issus des moyens de conversion 31 sont intégrés par les moyens de traitement 33 avant d'être analysés.

Dans un mode de test, un signal de test S_{T} multiplexé à l'image des trois signaux Ia, Ib, Ic est injecté par un générateur de courant dans le connecteur de test 239. Ce signal de test S_{T} passe par l'interface de protection 47 avant d'être converti en un signal de test numérique par les moyens de conversion analogique/numérique 31. Le signal de test numérique est vu par les moyens de traitement 33 comme un signal issu du bus primaire 9. Ce dernier analyse ce signal avant qu'il soit transmis par les moyens de sortie 43 aux équipements de protection et de surveillance.

On notera que lorsque le signal test est injecté dans le dispositif de traitement 21a, un contact s'établit entre le connecteur de test 239 et les moyens de traitement 33 permettant à ce dernier d'actionner les moyens de basculement 41 pour qu'il soit connecté au signal de test au lieu des signaux de haute tension.

Ainsi, le dispositif de traitement selon l'invention permet d'éviter toute connexion ou déconnexion dans la chaîne de mesure tout en utilisant des outils habituellement utilisés dans le domaine des tests électriques.

## Revendications

1. Dispositif de traitement de signal comportant des premiers moyens d'entrée (37) destinés à être connectés via un capteur (19) de mesure à un signal de haute tension d'une installation électrique (1), et des moyens de traitement (33) destinés à analyser le signal mesuré par ledit capteur, **caractérisé en ce qu'**il comporte :
- des moyens de basculement (41) configurés pour faire basculer le fonctionnement du dispositif entre un mode test dans lequel le dispositif est déconnecté dudit signal de haute tension pour être connecté à un signal de test et un mode opératoire dans lequel le dispositif est déconnecté dudit signal de test pour être reconnecté audit signal de haute tension, et
- des seconds moyens d'entrée (39) connectés auxdits moyens de traitement (33), lesdits moyens de traitement étant configurés pour actionner lesdits moyens de basculement (41) de telle sorte que le dispositif fonctionne en mode test ou en mode opératoire selon que les seconds moyens d'entrée sont activés ou désactivés respectivement.

2. Dispositif selon la revendication 1, **caractérisé en ce que** les seconds moyens d'entrée (39) comportent un connecteur (239) destiné à être raccordé à un générateur d'injection dudit signal de test et **en ce que** le raccordement audit générateur d'injection active les seconds moyens d'entrée (39) pour déclencher le basculement du dispositif en mode test.

3. Dispositif selon la revendication 2, **caractérisé en ce qu'**il comporte une interface d'entrée de protection (47) reliée audit connecteur (239).

4. Dispositif selon l'une quelconque des revendications précédentes, **caractérisé en ce qu'**il comporte une mémoire (35) comprenant au moins un signal de test préenregistré, et **en ce que** l'activation des seconds moyens d'entrée (39) déclenche le basculement du dispositif en mode test et le remplacement du signal haute tension par ledit signal de test préenregistré.

5. Dispositif selon l'une quelconque des revendications précédentes, **caractérisé en ce que** lesdits moyens de basculement (41) sont des moyens électroniques et/ou des moyens logiciels dont l'actionnement est commandé par les moyens de traitement.

6. Dispositif selon l'une quelconque des revendications précédentes, **caractérisé en ce que** ledit signal de test est un signal à l'image dudit signal de haute tension.

7. Dispositif selon l'une quelconque des revendications précédentes, **caractérisé en ce que** les premiers moyens d'entrée (37) comportent un connecteur d'alimentation (137) destiné à être connecté à une source d'alimentation et une pluralité de connecteurs (237a, 237b, 237c) de mesure destinés à être connectés à une pluralité de capteurs de mesure.

8. Dispositif selon l'une quelconque des revendications précédentes, **caractérisé en ce qu'**il comporte des moyens de conversion analogique/numérique (31) pour convertir le signal haute tension mesurée par ledit capteur en un signal numérique, et des moyens de sortie (43) pour délivrer une mesure numérique dudit signal.

9. Système de mesure d'une grandeur physique d'un signal électrique de haute tension comportant un dispositif de traitement selon l'une quelconque des revendications précédente, **caractérisé en ce qu'**il comporte au moins un capteur non conventionnel NCIT connecté audit dispositif de traitement par une liaison optique.

10. Installation électrique comportant le système de mesure selon la revendication 9.

## Patentansprüche

1. Vorrichtung zur Signalverarbeitung, umfassend erste Eingangsmittel (37), die dazu ausgelegt sind, mittels eines Messsensors (19) mit einem Hochspannungssignal einer elektrischen Anlage (1) verbunden zu sein, sowie Verarbeitungsmittel (33), die dazu ausgelegt sind, das von dem Sensor gemessene Signal zu analysieren, **dadurch gekennzeichnet, dass** sie umfasst:
- Umschaltmittel (41), die dazu ausgelegt sind, die Funktion der Vorrichtung zwischen einem Testmodus, in dem die Vorrichtung von dem Hochspannungssignal getrennt ist, um mit einem Testsignal verbunden zu sein, und einem Betriebsmodus umzuschalten, in dem die Vorrichtung von dem Testsignal getrennt ist, um wieder mit dem Hochspannungssignal verbunden zu sein, und
- zweite Eingangsmittel (39), die mit den Verarbeitungsmitteln (33) verbunden sind, wobei die Verarbeitungsmittel dazu ausgelegt sind, die Umschaltmittel (41) derart zu betätigen, dass die Vorrichtung im Testmodus oder im Betriebsmodus funktioniert, je nachdem, ob die zweiten Eingangsmittel aktiviert beziehungsweise deaktiviert sind.

2. Vorrichtung nach Anspruch 1, **dadurch gekennzeichnet, dass** die zweiten Eingangsmittel (39) einen Verbinder (239) umfassen, der dazu ausgelegt ist, an einen Generator zum Injizieren des Testsignals angeschlossen zu sein, und dass der Anschluss an den Injektionsgenerator die zweiten Eingangsmittel (39) aktiviert, um das Umschalten der Vorrichtung in den Testmodus auszulösen.

3. Vorrichtung nach Anspruch 2, **dadurch gekennzeichnet, dass** sie eine Eingangsschutzschnittstelle (47) umfasst, die mit dem Verbinder (239) verbunden ist.

4. Vorrichtung nach einem der vorhergehenden Ansprüche, **dadurch gekennzeichnet, dass** sie einen Speicher (35) umfasst, der wenigstens ein zuvor abgespeichertes Testsignal enthält, und dass die Aktivierung der zweiten Eingangsmittel (39) das Umschalten der Vorrichtung in den Testmodus und das Ersetzen des Hochspannungssignals durch das zuvor abgespeicherte Testsignal auslöst.

5. Vorrichtung nach einem der vorhergehenden Ansprüche, **dadurch gekennzeichnet, dass** die Umschaltmittel (41) elektronische Mittel und/oder Softwaremittel sind, deren Betätigung durch die Verarbeitungsmittel gesteuert wird.

6. Vorrichtung nach einem der vorhergehenden Ansprüche, **dadurch gekennzeichnet, dass** das Testsignal ein Bildsignal des Hochspannungssignals ist.

7. Vorrichtung nach einem der vorhergehenden Ansprüche, **dadurch gekennzeichnet, dass** die ersten Eingangsmittel (37) einen Versorgungsverbinder (137) umfassen, der dazu ausgelegt ist, mit einer Versorgungsquelle verbunden zu sein, sowie eine Mehrzahl von Messverbindern (237a, 237b, 237c), die dazu ausgelegt sind, mit einer Mehrzahl von Messsensoren verbunden zu sein.

8. Vorrichtung nach einem der vorhergehenden Ansprüche, **dadurch gekennzeichnet, dass** sie Mittel (31) zur Analog/Digital-Umwandlung umfasst, um das durch den Sensor gemessene Hochspannungssignal in ein digitales Signal umzuwandeln, sowie Ausgangsmittel (43) zum Liefern einer digitalen Messung des Signals.

9. System zur Messung einer physikalischen Größe eines elektrischen Hochspannungssignals, umfassend eine Verarbeitungsvorrichtung nach einem der vorhergehenden Ansprüche, **dadurch gekennzeichnet, dass** sie wenigstens einen nicht herkömmlichen NCIT-Sensor umfasst, der mittels einer optischen Verbindung mit der Verarbeitungsvorrichtung verbunden ist.

10. Elektrische Anlage, umfassend das Messsystem nach Anspruch 9.

## Claims

1. A signal processor device comprising: first input means (37) intended to be connected, via a measurement sensor (19), to a high-voltage signal of an electrical installation (1); and processor means (33) for analyzing the signal measured by said sensor; the device being **characterized in that** it further comprises:
• changeover means (41) that are configured to cause the operation of the device to change between a test mode in which the device is disconnected from said high-voltage signal so as to be connected to a test signal, and an operating mode in which the device is disconnected from said test signal so as to be reconnected to said high-voltage signal; and
• second input means (39) that are connected to said processor means (33), said processor means being configured to actuate said changeover means (41) so that the device operates in test mode or in operating mode depending on whether the second input means are activated or de-activated respectively.

2. A device according to claim 1, **characterized in that** the second input means (39) include a connector (239) intended to be connected to an injector generator for injecting said test signal, and **in that** connection to said injector generator activates the second input means (39) so as to trigger the device to change into test mode.

3. A device according to claim 2, **characterized in that** it includes a protective input interface (47) that is connected to said connector (239).

4. A device according to any preceding claim, **characterized in that** it includes a memory (35) storing at least one pre-recorded test signal, and **in that** the activation of the second input means (39) triggers the device to change into test mode and the high-voltage signal to be replaced by said pre-recorded test signal.

5. A device according to any preceding claim, **characterized in that** said changeover means (41) are electronic means and/or software means that are actuated under the control of the processor means.

6. A device according to any preceding claim, **characterized in that** said test signal is a signal that replicates said high-voltage signal.

7. A device according to any preceding claim, **characterized in that** the first input means (37) include a power connector (137) intended to be connected to a power source, and a plurality of measurement connectors (237a, 237b, 237c) intended to be connected to a plurality of measurement sensors.

8. A device according to any preceding claim, **characterized in that** it includes analog-to-digital conversion means (31) for converting the high-voltage signal measured by said sensor into a digital signal, and output means (43) for delivering a digital measurement of said signal.

9. A measurement system for measuring a physical unit of a high-voltage electrical signal, said system including a processor device according to any preceding claim, and being **characterized in that** it includes at least one nonconventional NCIT sensor that is connected to said processor device via an optical connection.

10. An electrical installation including the measurement system according to claim 9.
